Europäisches Patentamt

European Patent Office

Office européen des brevets

(11) Publication number: **0 260 039 B1**

# EUROPEAN PATENT SPECIFICATION

(45) Date of publication of patent specification: **10.07.91**  (51) Int. Cl.⁵: **G11C 11/406, G11C 7/00**

(21) Application number: **87307618.6**

(22) Date of filing: **27.08.87**

(54) **Dynamic random access memory.**

(30) Priority: **27.08.86 JP 198938/86**

(43) Date of publication of application:
**16.03.88 Bulletin 88/11**

(45) Publication of the grant of the patent:
**10.07.91 Bulletin 91/28**

(84) Designated Contracting States:
**DE FR GB**

(56) References cited:
**EP-A- 0 081 381**
**EP-A- 0 109 069**
**EP-A- 0 145 582**
**EP-A- 0 153 469**
**DE-A- 3 305 501**

**SOVIET INVENTIONS ILLUSTRATED, section
E1, week 8341, November 23, 1983 DERWENT
PUBLICATIONS LTD. London U14**

(73) Proprietor: **FUJITSU LIMITED**
**1015, Kamikodanaka Nakahara-ku**
**Kawasaki-shi Kanagawa 211(JP)**

Proprietor: **FUJITSU VLSI LIMITED**
**1844-2, Kozoji-cho 2-chome**
**Kasugai-shi Aichi 487(JP)**

(72) Inventor: **Nakano, Tomio**
**3-1-27-103, Sugesengoku Tama-ku**
**Kawasaki-shi Kanagawa 214(JP)**
Inventor: **Nomura, Hidenori**
**466-18, Eda-cho Midori-ku**
**Yokohama-shi Kanagawa 227(JP)**

(74) Representative: **Fane, Christopher Robin King**
**et al**
**HASELTINE LAKE & CO. Hazlitt House 28**
**Southampton Buildings Chancery Lane**
**London, WC2A 1AT(GB)**

**Description**

The present invention relates to a semiconductor memory device, and more particularly, to a dynamic random access memory (DRAM).

In a DRAM, the data is stored in a capacitor of a memory cell on the basis of whether or not there is a charge in the capacitor. Accordingly, the data must be refreshed to hold it in the capacitor, since the data will be lost with the elapse of time, due to a leakage of current from the capacitor.

Therefore, a DRAM is set to operate in two modes, i.e. a read/write mode for reading or writing the data, and a refresh mode for refreshing the data. Although the operational speed of such a DRAM depends on the read/write and the refresh operational speeds at those modes, the timing of the refresh mode particularly can be an important factor in determining the operational speed of the DRAM.

Accordingly, it is desirable to provide a dynamic random access memory having improved refresh timing, with a view to increasing the operational speed of the DRAM.

According to the present invention, there is provided a dynamic random access memory comprising: a plurality of dynamic-type memory cells, arranged in rows and columns, for storing respective items of data; refresh control circuitry for causing the data in selected ones of those memory cells to be refreshed, when the memory is in a refresh mode, and including refresh address circuitry for generating refresh address signals denoting memory cells to be refreshed; and clock signal generating circuitry connected to receive row address strobe signals and column address strobe signals and operating in dependence thereon to generate a first clock signal, when a preset length of time has elapsed after receipt of a row address strobe signal , and to generate second and third clock signals in response to the said first clock signal, the said second clock signal being generated during a read/write mode of the memory and being delivered to addressing circuitry of the memory so as to cause that circuitry to latch an external address signal supplied thereto, and the said third clock signal being generated during the said refresh mode and being delivered to the said addressing circuitry, so as to cause that circuitry to latch a refresh address signal supplied thereto;

characterised in that the said clock signal generating circuitry includes signal modifying means including loading circuitry operative during the said refresh mode, said loading circuitry reducing the rate of change of an intermediate signal derived from the column address strobe signal and employed to determine the timing of the said third clock signal, thereby to cause the time delay between the said first and third clock signals, during the said refresh mode, to be greater than that between the said first and second clock signals during the said read/write mode.

Reference will now be made, by way of example, to the accompanying drawings, in which:

Fig. 1 shows a circuit diagram of a clock generator previously considered by the present applicants;

Fig. 2 shows a circuit diagram of an address latch circuit and peripheral circuits previously considered by the present applicants;

Fig. 3 shows a timing chart for each clock signal of Fig. 1 during a read/write mode;

Fig. 4 shows a timing chart for each clock signal of Fig. 1 during a refresh mode;

Fig. 5 shows a chart for explaining timing of row and column address strobe signals in the read/write mode;

Fig. 6 shows a chart for explaining timing of row and column address strobe signals in the refresh mode;

Fig. 7 shows a circuit diagram of clock signal generating circuitry of a DRAM embodying the present invention;

Fig. 8 shows a circuit diagram of addressing circuitry of a DRAM embodying the present invention;

Fig. 9 shows a timing chart for each clock signal of Fig. 7 during a read/write mode;

Fig. 10 shows a timing chart for each clock signal of Fig. 7 during a refresh mode;

Fig. 11 shows a circuit diagram of clock signal generating circuitry of a further DRAM embodying the present invention;

Fig. 12 shows a circuit diagram of addressing circuitry of the further DRAM embodying the present invention;

Fig. 13 shows a timing chart for each clock signal of Fig. 11 during a read/write mode;

Fig. 14 shows a timing chart for each clock signal of Fig. 11 during a refresh mode; and

Fig. 15 shows a schematic block diagram of a DRAM embodying the present invention.

Before describing the preferred embodiments, an explanation will be given of read/write and refresh timing in a DRAM previously considered by the present applicants.

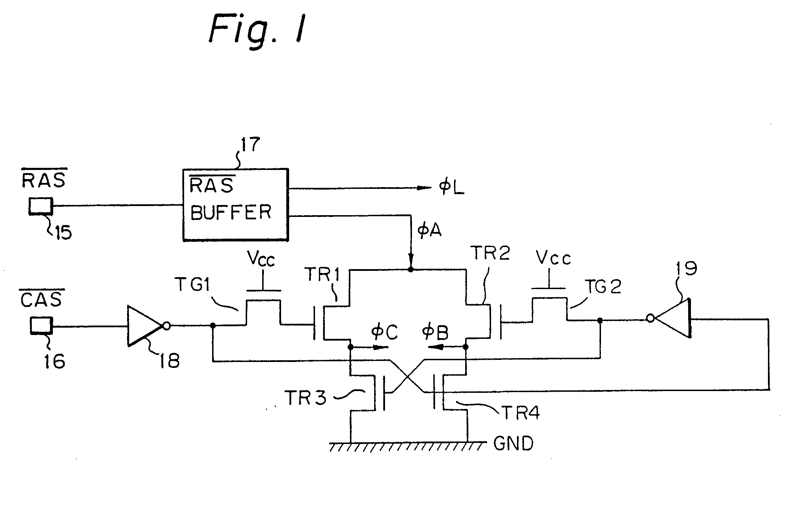

In the clock signal generator illustrated in Fig. 1, $\overline{RAS}$ denotes a row address strobe signal, $\overline{CAS}$ a column address strobe signal, and ØA, ØB, ØC and ØL internal clock signals. TG1 and TG2 denote gate transistors, and TR1 to TR4 transistors. Further, reference numbers 15 and 16 denote input terminals, 17 a RAS buffer, and 18 and 19 inverters. $V_{CC}$ denotes a first power source and GND a second power source, i.e. ground.

The signals $\overline{RAS}$ and $\overline{CAS}$ are input from an external circuit of the DRAM to the input terminals 15 and 16 for setting the read/write mode and the refresh mode. The clocks ØA and ØL are generated from the RAS buffer 17 after a predetermined delay time. In this case, the delay time of the clock ØA is different from that of the clock ØL, as explained below. The clock ØB is obtained from a common node of the transistors TR2 and TR4, and the clock ØC is obtained from a common node of the transistors TR1 and TR3. That is, when the transistor TR2 is ON and the transistor TR4 is OFF, the clock øB is at a high level. When the transistor TR1 is ON and the transistor TR3 is OFF, the clock øC is at a high level as explained below.

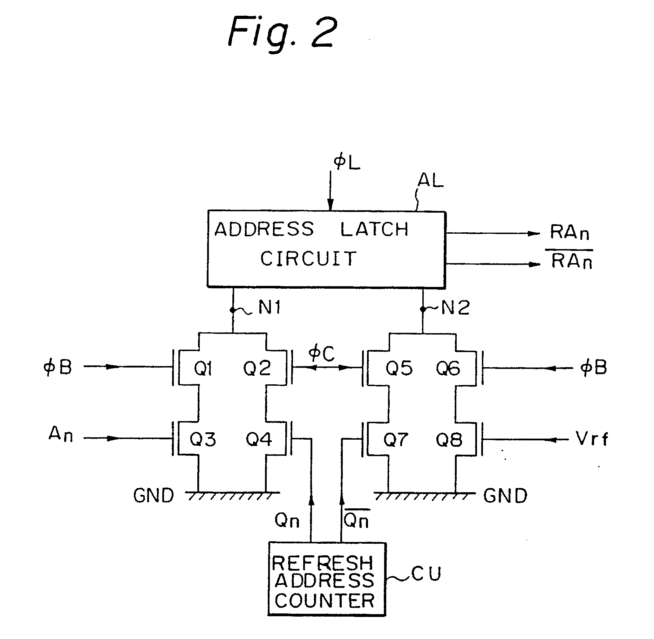

In Fig. 2, AL denotes an address latch circuit constituted by, for example, flip-flop circuits, and CU denotes a refresh address counter. N1 denotes a first input connection point (first node), and N2 a second input connection point (second node). Q1 to Q8 denote transistors constituting a peripheral circuit. $A_n$ denotes an input address signal (TTL level) from an external stage (not shown), $Q_n$ a refresh address signal from the refresh address counter CU, $\overline{Q_n}$ a complementary refresh address signal of the signal $Q_n$ , $RA_n$ a latched address signal (MOS level) from the address latch circuit AL, $\overline{RA_n}$ a complementary latched address signal (MOS level) of the signal $RA_n$ , and $V_{rf}$ a reference voltage level (approximately, 1.5 volts) generated from the internal circuit (not shown). The clocks øB, øC and øL are input from the clock generator shown in Fig. 1. In this case, the clock øL is used for activating the address latch circuit AL, the clock øB for controlling the input address signal $A_n$ , and the clock øC for controlling the refresh address signals $Q_n$ and $\overline{Q_n}$.

In the read/write mode, the charge of the node N1 is discharged in correspondence with the data of the external address signal $A_n$ through the transistors Q1 and Q3 when the clock øB is high. The charge of the node N2 is discharged through the transistors Q6 and Q8. In this case, since the reference voltage $V_{rf}$ is set to an intermediate level of an amplitude of the input address signal $A_n$ , the discharge quantity of the node N2 is different from that of the node N1. As a result, the external address signal $A_n$ can be taken into the address latch circuit AL.

In the refresh mode, the charge of the node N1 is discharged in correspondence with the signal $Q_n$ from the refresh counter CU through the transistors Q2 and Q4 when the clock øC is high. The charge of the node N2 is discharged in correspondence with the signal $\overline{Q_n}$ from the refresh counter CU through the transistors Q5 and Q7.

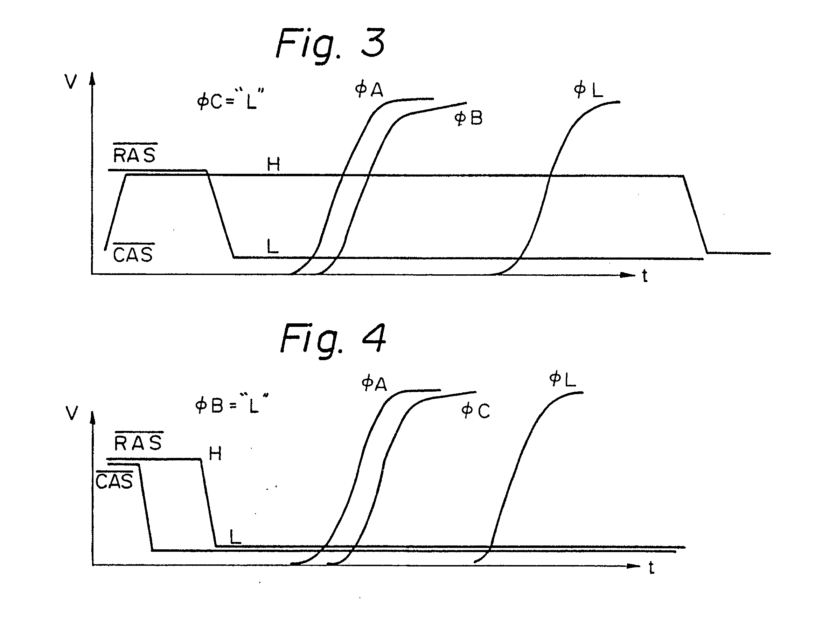

With reference to Figs. 3 and 4, in which the ordinate V denotes voltage and the abscissa t denotes time, the row address strobe $\overline{RAS}$ and the column address strobe $\overline{CAS}$ are taken to be the respective trailing edges of the strobe signal waveform. The clock øA is obtained from the $\overline{RAS}$ buffer 17 and this clock is delayed by a predetermined delay time from the trailing edge of the signal $\overline{RAS}$.

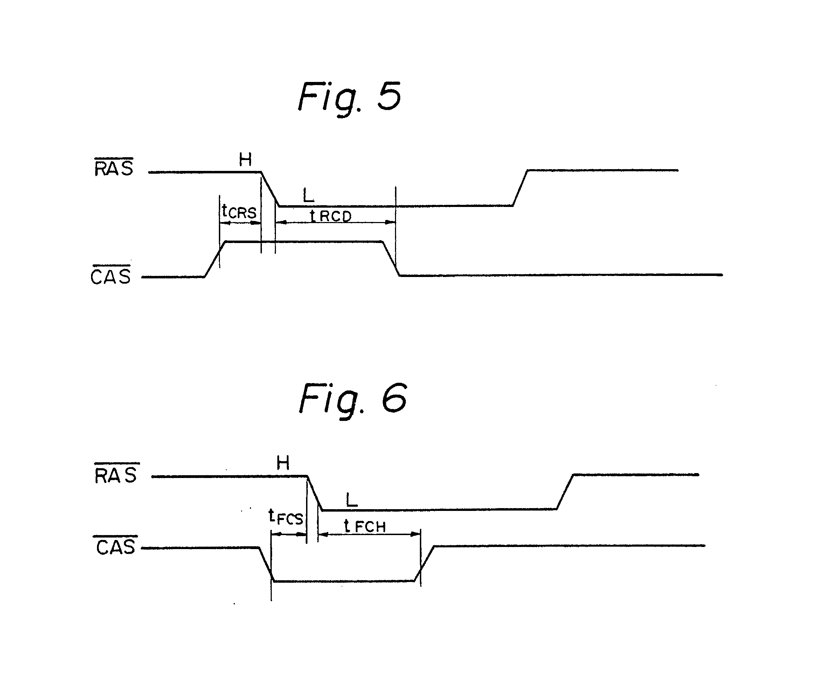

The timing chart of Fig. 5 denotes the read/write mode, hereinafter called the "normal cycle", wherein $t_{CRS}$ denotes a set-up time of the signal $\overline{CAS}$ to signal $\overline{RAS}$, and $t_{RCD}$ is a delay time between the signal $\overline{RAS}$ and the signal $\overline{CAS}$.

The timing chart of Fig. 6 denotes the refresh mode, hereinafter called the "CBR refresh cycle" where "CBR" means that the signal $\overline{CAS}$ is dropped from a high level to a low level before the signal $\overline{RAS}$ has dropped from a high level to a low level. In Fig. 6, $t_{FCS}$ denotes a set-up time of the signal $\overline{CAS}$ to the signal $\overline{RAS}$ for the refresh operation, and $t_{FCH}$ denotes a hold time of the signal $\overline{CAS}$ from the signal $\overline{RAS}$ for the refresh operation.

In the normal cycle, the row address strobe signal $\overline{RAS}$ is changed from high level (H) to low level (L) when the row address signal is taken in from the external stage. At this time, the column address strobe signal $\overline{CAS}$ is held at the high level. In the CBR refresh cycle, the signal $\overline{CAS}$ is changed from high level to low level before the signal $\overline{RAS}$ is changed from high level to low level. This trailing timing of the signal $\overline{CAS}$ is detected in the clock generator shown in Fig. 1 and the generated clock øC is input to the transistors Q2 and Q5 shown in Fig. 2.

The operations of the previously-considered normal cycle and the CBR refresh cycle are explained in detail hereinafter.

Referring first of all to the normal cycle, in Fig. 3, the clock øA rises from low level to high level after a predetermined delay time from the trailing edge of the signal $\overline{RAS}$. The clock øA is input to the transistors TR1 and TR2 shown in Fig. 1.

In the normal cycle, since the signal $\overline{CAS}$ is high, the output of the inverter 18 is low so that the transistor TR4 is turned OFF and, since the output of the inverter 19 is high, the transistor TR3 is turned ON. Further, the transistor TR1 is turned OFF and the transistor TR2 is turned ON. Therefore, the clock øB is high and the clock øC is low. The clock øB is input to the transistors Q1 and Q6 shown in Fig. 2.

In Fig. 2, the address latch circuit AL is constituted by, for example, flip-flop circuits as explained above. Therefore, the transistors Q1 to Q8 are provided for forming current paths to discharge the charge in the flip-flop circuits. As shown in the drawing, the node N1 is connected to the ground GND through either a first current path, consisting of the transistors Q1 and Q3, or a second current path, consisting of the transistors Q2 and Q4. Further, the node N2 is connected to the ground GND through either a third current path, consisting of the transistors Q5 and Q7, or a fourth current path, consisting of the transistors Q6 and Q8.

When the clock $\phi$B is input to the transistors Q1 and Q6, these transistors are turned ON. The transistor Q3 is turned ON or OFF in correspondence with the high or low level of the input address signal $A_n$. In this case, when the transistor Q3 is turned ON, the charge of the node N1 is completely discharged to the ground GND. Since the reference voltage $V_{rf}$ is set to an intermediate level between the high level and the low level at the input address signal $A_n$ , the transistor Q8 is not completely turned ON so that the discharge quantity from the node N2 is smaller than that of the node N1. Consequently, when the transistor Q3 is completely turned ON, the node N1 is discharged and becomes low level. When the transistor Q3 is completely turned OFF, the node N1 is held at the high level. At this time, the node N2 is discharged and becomes low level since the transistor Q8 is turned ON at the intermediate state (i.e. incomplete turning ON state). As a result, the external address signal $A_n$ is latched in the address latch circuit AL and the data based on the latched address signal is output in correspondence with the clock $\phi$L based on the row address signal $\overline{RA_n}$ or the complementary signal $RA_n$ from the circuit AL.

Referring now to the CBR refresh cycle, in this cycle the clock $\phi$C rises from low level to high level as shown in Fig. 4. That is, in Fig. 1, since the signal $\overline{CAS}$ is low, the output of the inverter 18 is high so that the transistor TR4 is turned ON. But, since the output of the inverter 19 is low, the transistor TR3 is turned OFF. Further, the transistor TR1 is turned ON and the transistor TR2 is turned OFF. Therefore, the clock $\phi$C is high and the clock $\phi$B is low.

In Fig. 2, the clock $\phi$C is input to the transistors Q2 and Q5. Therefore, these transistors Q2 and Q5 are turned ON. The transistor Q4 is turned ON and the transistor Q7 is turned OFF when the refresh address signal $Q_n$ is high and the complementary refresh address signal $\overline{Q_n}$ is low. Further, the transistor Q7 is turned ON and the transistor Q4 is turned OFF when the signal $Q_n$ is low and the signal $\overline{Q_n}$ is high. The charge of the node N1 is discharged and becomes low level when the transistor Q4 is turned ON. The charge of the node N2 is discharged and becomes low level when the transistor Q7 is turned ON. Consequently, the refresh address signal from the counter CU is taken into the address latch circuit AL. The data based on the latched refresh address signal is output in correspondence with the clock $\phi$L based on the row address signal $RA_n$ and the complementary signal $\overline{RA_n}$.

As shown in Fig. 6, it is necessary to drop the signal $\overline{CAS}$ from a high level to a low level before the signal $\overline{RAS}$ is dropped from a high level to a low level. Further, it is necessary to set the set-up time $t_{FCS}$ so that it is larger than the delay time caused by the inverters 18 and 19. In the normal cycle, it is necessary to raise the signal $\overline{CAS}$ from low level to high level before the signal $\overline{RAS}$ is dropped from high level to low level, as shown in Fig. 5. Approximately 10 to 20 nanoseconds are necessary for the set-up time $t_{CRS}$.

As is well-known, the row address strobe signal $\overline{RAS}$ is the earliest clock, based on the system operation speed. However, in the CBR refresh cycle, the column address strobe signal $\overline{CAS}$ must be input before the signal $\overline{RAS}$ is input. Therefore, some problems arise regarding this early input timing of the signal $\overline{CAS}$. For example, it is not obvious whether or not the level of the $\overline{CAS}$ to be input is high in an initial state of a central processing unit (CPU). Therefore, a delay of approximately 50 nanoseconds occurs for inputting the signal $\overline{CAS}$, since the signal $\overline{CAS}$ is input after determination by the CPU. Consequently, it is very difficult to achieve a high speed operation of the DRAM, owing to these delay times for the set-up time.

A dynamic random access memory, having improved refresh timing, which embodies the present invention will be explained in detail hereinafter.

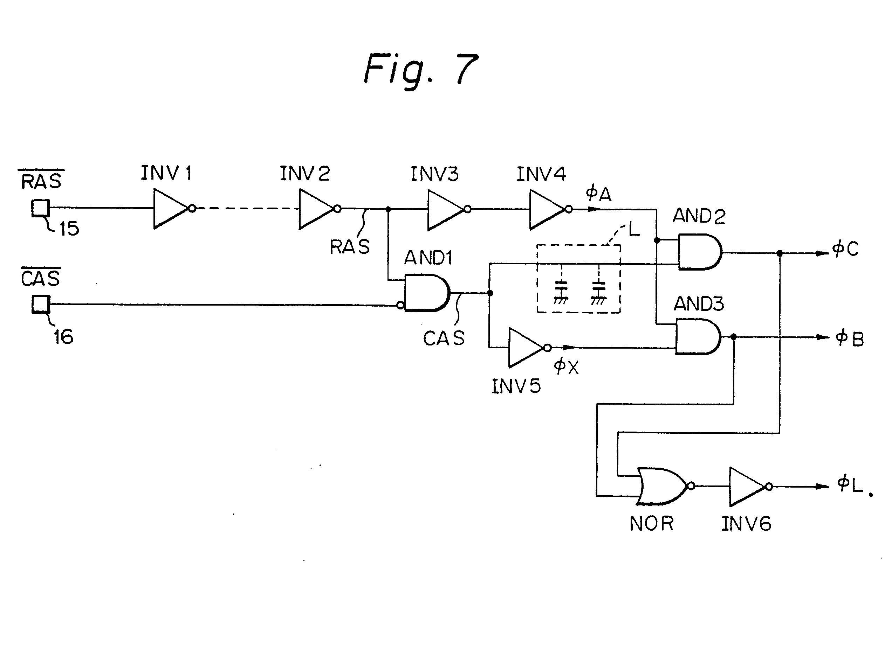

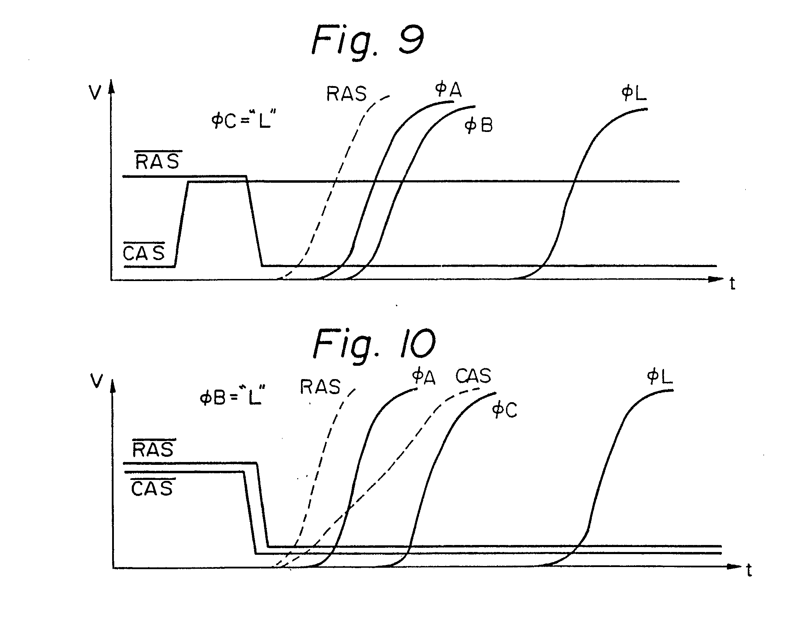

In Fig. 7, INV 1 to INV 6 denote inverters. AND 1 to AND 3 denote AND gates. The signal $\overline{RAS}$ is delayed by a plurality of inverters INV 1 to INV 4 and the clock $\phi$A is obtained from the inverter INV 4. The inverters INV 1 to INV 4 correspond to the $\overline{RAS}$ buffer 17 shown in Fig. 1. However, in an embodiment of the present invitation, an inverted $\overline{RAS}$ signal (RAS) delayed by the inverters INV 1 to INV 2 is input to one input terminal of the gate AND 1. The signal $\overline{CAS}$ is inverted to an opposite level signal CAS in the other input terminal of the gate AND 1. Therefore, the signal CAS is obtained when the signal $\overline{CAS}$ is low. In this case, the signal RAS is always high. An internal clock $\phi$X is obtained by inverting the signal CAS. Therefore, the clock $\phi$C is obtained through the gate AND 2 when the clock $\phi$A and the signal CAS are high. The clock $\phi$B is obtained through the gate AND 3 when both clocks $\phi$A and $\phi$X are high. The clock $\phi$L is obtained through a NOR gate and the inverter INV 6, except when both clocks $\phi$B and $\phi$C are low. Further, many loads, for example, capacitive loads of other clock generators, are shown by a dotted line L. The gate AND 1 and the loading circuitry L together constitute signal modifying means. The signal CAS is sent to these loads so that the leading edge of the signal CAS becomes a gentle slope, as shown by a dotted line in Fig. 10. The present invention utilizes this gentle slope of the signal CAS. The operation of this circuit will be explained in detail hereinafter.

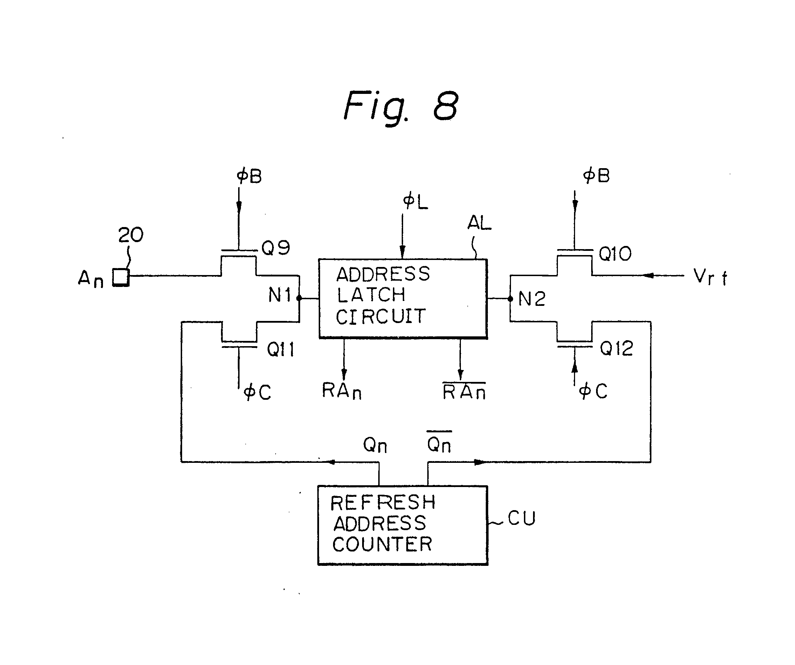

In Fig. 8, Q9 to Q12 denote transistors. The external input address signal $A_n$ is input to an input terminal 20. As is obvious from the drawing, the signals $A_n$, $V_{rf}$, $Q_n$ and $\overline{Q_n}$ are input to either the source or the drain side of transistors $Q_9$ to $Q_{12}$ respectively. Conventionally, these signals are input to the gate side of each transistor as shown in Fig. 2. Therefore, each of transistors Q9 to Q12 is used only as a gate transistor. That is, the transistor Q9 is used for taking in the external address signal $A_n$ when the clock øB is high in the normal cycle; the transistor Q10 is used for taking in the reference voltage $V_{rf}$ when the clock øB is high in the normal cycle; the transistor Q11 is used for taking in the internal refresh address signal $Q_n$ when the clock ØC is high in the CBR refresh cycle; and the transistor Q12 is used for taking in the complementary refresh address signal $\overline{Q_n}$ when the clock øC is high in the CBR refresh cycle.

The operation of the circuits shown in Figs. 7 and 8 will be explained in detail with reference to Figs. 9 and 10.

In the normal cycle shown in Fig. 9, the clock øB is generated from the gate AND 3 when both clocks øA and øX are high. That is, the signal $\overline{CAS}$ is high in the normal cycle, and the signal CAS generated from the gate AND 1 is low since the signal RAS is high. Therefore, the internal clock øX is high so that the clock øB is output from the gate AND 3, since the clock øA is high. In this case, the clock øC from the gate AND 2 is low, since the clock øA is high and the signal CAS is low. Therefore, the clock øL is output through the NOR gate and the inverter INV 6 when the clock øB is high.

In the CBR refresh cycle shown in Fig. 10, the clock øC is generated from the gate AND 2 when the signal CAS and the clock øA are high. That is, the signal $\overline{CAS}$ is low in the CBR refresh cycle, and the signal CAS is high since the signal RAS is high. In this case, the clock øB is low, since the clock øA is high and the clock øX is low. Therefore, the clock øL is output through the NOR gate and the inverter INV 6 when the clock øC is high.

As shown by a dotted line in the drawing, the starting point of the leading edge of the signal CAS is earlier than that of the clock øA. However, the time at which it is completely raised is later than that of the clock øA. That is, the leading edge of the signal CAS becomes a gentle slope caused by many loads. Therefore, the time when the clock øA and the signal CAS become high level is delayed so that the leading time of the clock øC depends on the leading edge of the signal CAS. This is because, as explained above, many loads, for example capacitive loads (see Fig. 7), are provided to the output of the gate AND 1 for utilizing the signal CAS.

In an embodiment of the present invention, the difference of the leading time between the clock øB and the clock øC is utilized. That is, in the normal cycle shown in Fig. 9, the clock øB immediately rises since the internal clock øX is high because the signal CAS is low. But, in the CBR refresh cycle, the clock øC rises after the signal CAS is completely raised for the above explained reason, although the clock øA has already risen. Therefore, each of the gate transistors Q9 to Q12 shown in Fig. 8 is opened in correspondence with the input timing of these clocks øB and øC in the normal and the CBR refresh cycles.

In Fig. 8, when the clock øB is input to the transistors Q9 and Q10 in the normal mode, these transistors are turned ON so that the external address signal $A_n$ is input to the address latch circuit AL through the node N1 and the reference voltage $V_{rf}$ is also input to the circuit AL through the node N2. The difference voltage between the signal $A_n$ and the reference voltage $V_{rf}$ is detected in the circuit AL and the row address signal $RA_n$ and the complementary row address signal $\overline{RA_n}$ are output from the circuit AL in correspondence with the clock øL after this difference voltage is amplified. In this case, the clock øL is generated at the same timing in the normal and CBR refresh cycles, to obtain a stable operation of the circuit AL in these cycles.

When the clock øC is input to the transistors Q11 and Q12 in the CBR refresh cycle, these transistors are turned ON so that the refresh address signal $Q_n$ and the complementary refresh address signal $\overline{Q_n}$ are input to the circuit AL through the nodes N1 and N2. As a result, the latched row address signal $RA_n$ and the complementary signal $\overline{RA_n}$ are output from the circuit AL.

In an embodiment of the present invention, it is possible to set the refresh set-up time $t_{FCS}$ (see Fig. 6) so that it will become zero. That is, it is possible to set the same timing of the trailing edge between the signal $\overline{RAS}$ and the signal $\overline{CAS}$ as shown in Fig. 10. Further, it is possible to set the later timing of the trailing edge than the signal $\overline{RAS}$. These are because the inverters 18 and 19 (see Fig. 1) are not provided in the clock generator shown in Fig. 7, since the timing of the clock øB is different from that of the clock øC. Consequently, it is possible to achieve a high speed operation of the system. As explained above, in the previously-considered clock generation shown in Fig. 1, the timing of the clock øB is the same as that of the clock øC, so that the inverters 18 and 19 are necessary. Therefore, it is necessary to set the refresh set-up time $t_{FCS}$ to a time sufficient to cover the delay time caused by these inverters 18 and 19 in the previously-considered clock generator.

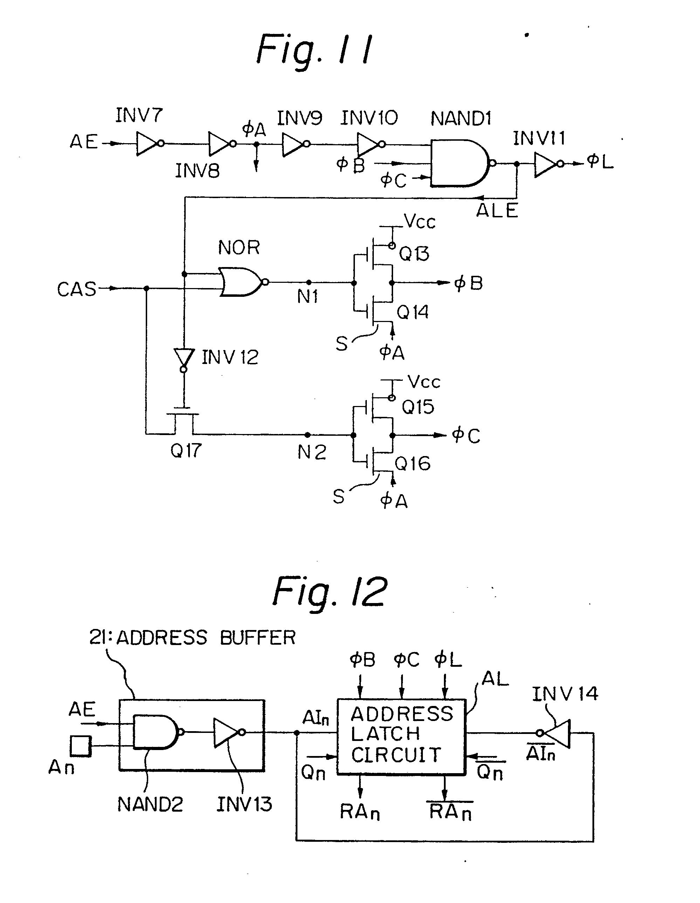

In Figs. 11 and 12, two CMOS (complementary metal oxide semiconductor) inverters are used in the clock generator, instead of the N-channel transistor used in the first embodiment shown in Fig. 7. In the case of a CMOS, the circuit can be operated by either a negative or a positive logic. But, in the case of the N-channel transistor, the circuit can be operated only by a positive logic. In general, the negative logic is better than the positive logic because the trailing operation of the signal is easier than the leading operation of the signal.

In Fig. 11, AE denotes a delay signal delayed from the signal $\overline{RAS}$, ALE a control signal for controlling generation of the clocks øB and øC, Q13 and Q15 P-channel MOS transistors, and Q14 and Q16 N-channel MOS transistors. The pair of transistors $Q_{13}$ and $Q_{14}$ and the pair of transistors Q15 and Q16 constitute respective CMOS inverters. The clock øA is obtained from the signal AE after a delay by inverters INV 7 and INV 8. This clock øA is input to the source of the transistors Q14 and Q16. The clock øB is obtained from a common node of the transistors Q13 and Q14, and the clock øC is obtained from a common node of the transistors Q15 and Q16. The clocks øB and øC are input to the NAND gate, to achieve a quick operation of the NAND gate.

In Fig. 12, 21 denotes an address buffer comprising a NAND gate NAND 2 and an inverter INV 13. The address buffer 21 amplifies the external address signal $A_n$ having a TTL level voltage to a clock $AI_n$ having a MOS level voltage in correspondence with the timing of the signal AE. The clock $AI_n$ is input to the address latch circuit AL and the complementary clock $\overline{AI_n}$ inverted by the inverter INV 14 is also input to the address latch circuit AL.

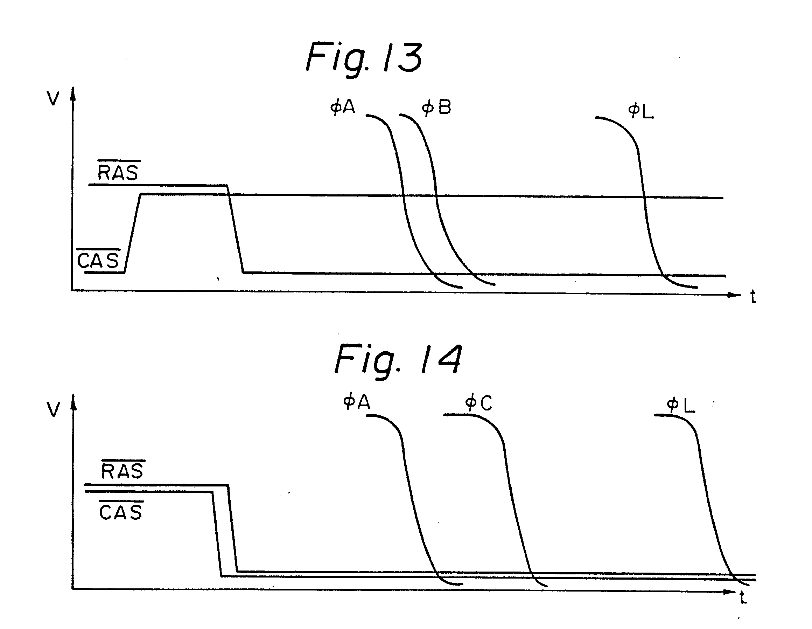

The operations of the circuits shown in Figs. 11 and 12 will be explained in detail with reference to Figs. 13 and 14.

In the normal cycle shown in Fig. 13, initially the node N1 is high. When the signal AE is dropped from a high level to a low level, the clock øA also drops from a high level to a low level after a delay due to the two inverters INV7 and INV8. Therefore, the clock øB becomes low level since the clock øA is input to the source S of the transistor Q14. Further, when the signal ALE becomes high level after delay due to the inverters INV9 and INV10 and the gate NAND1, the node N1 becomes low level through the gate NOR and the clock øB becomes high level (not shown). In the circuit shown in Fig. 11, since the clock øB functions as "one shot pulse", only the curve from high level to low level is shown in Fig. 13.

In the CBR refresh cycle shown in Fig. 14, initially the node N2 is low. However, since the signal CAS becomes high level before the signal AE becomes low level, the node N2 becomes high level and, then the node N1 becomes low level. Further, since the signal AE becomes low level, the clock øA also becomes low level so that the clock øC becomes low level through the source S of the transistor Q16. Further, since the signal ALE becomes high level, the node N2 becomes low level so that the clock øC becomes high level (not shown). In the circuit shown in Fig. 11, since clock øC functions as "one shot pulse", only the curve from high level to low level is shown in Fig. 14.

As is obvious from the above, when the node N1 is high, the clock øB is output, and when the node N2 is high, the clock øC is output, in correspondence with the timing of the clock øA. In this case, as explained above, the leading time of the signal CAS becomes a gentle slope, since many loads are connected in the path of the signal CAS.

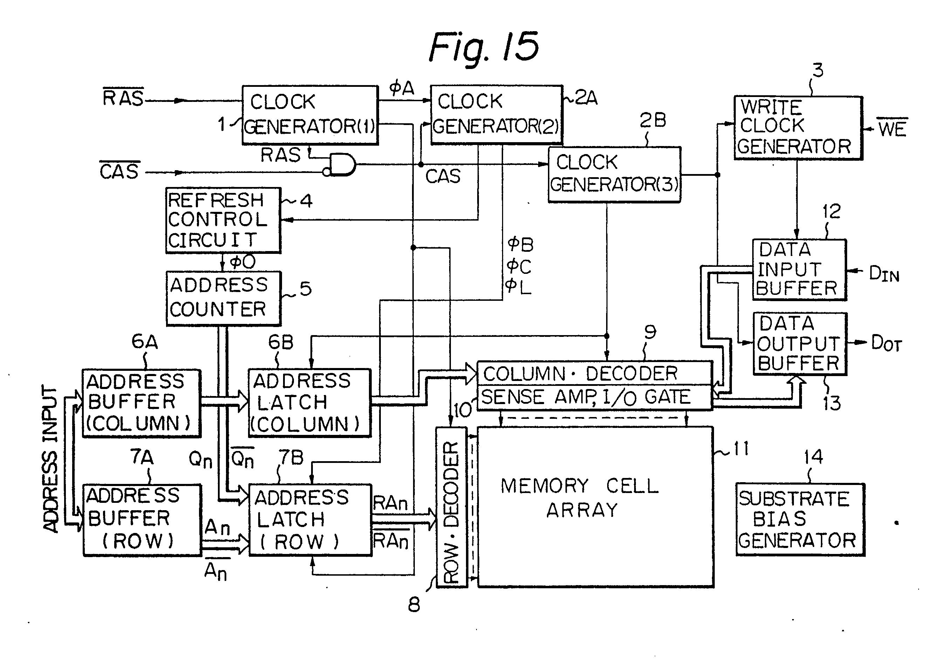

In Fig. 15, a MOS (metal oxide semiconductor) DRAM embodying the present invention comprises: a first clock generator 1 for generating clocks, for example øA, RAS, AE, etc.; a second clock generator 2A for generating clocks, for example, øB, øC, øL, ALE, etc. to activate a row address; a third clock generator 2B for generating clocks to control read/write operations for a column address; a write clock generator 3 for controlling a read/write mode based on an input write enable signal $\overline{WE}$; a refresh control circuit 4 for generating a clock øO to control the operation of the internal refresh counter in the CBR refresh cycle; an address counter for generating an internal address signal for a refresh operation; an address buffer for a column side 6A and an address buffer for a row side 7A, each converting an input address level to an internal CMOS level; an address latch circuit for a column side 6B and an address latch circuit for a row side 7B, each latching an external address signal and a refresh address signal; a data input buffer 12 for converting the level of an input data $D_{IN}$ to an internal CMOS level; a data output buffer 13 for amplifying an output data $D_{OT}$; a substrate bias generator 14 for generating a back bias voltage; a memory cell array constituted by a plurality of DRAM cells; row and column decoders 8 and 9; and a sense amplifier - I/O gate 10.

**Claims**

1.  A dynamic random access memory comprising:

    a plurality (11) of dynamic-type memory cells, arranged in rows and columns, for storing respective items of data;

    refresh control circuitry (4, 5) for causing the data in selected ones of those memory cells to be refreshed, when the memory is in a refresh mode, and including refresh address circuitry (5) for generating refresh address signals ($Q_n$, $\overline{Q_n}$) denoting memory cells to be refreshed; and

clock signal generating circuitry (1, 2A) connected to receive row address strobe signals ($\overline{RAS}$) and column address strobe signals ($\overline{CAS}$) and operating in dependence thereon to generate a first clock signal ($\emptyset A$), when a preset length of time has elapsed after receipt of a row address strobe signal ($\overline{RAS}$), and to generate second ($\emptyset B$) and third ($\emptyset C$) clock signals in response to the said first clock signal ($\emptyset A$), the said second clock signal ($\emptyset B$) being generated during a read/write mode of the memory and being delivered to addressing circuitry (Q9, Q10, Q11, Q12, AL) of the memory so as to cause that circuitry to latch an external address signal ($A_n$) supplied thereto, and the said third clock signal ($\emptyset C$) being generated during the said refresh mode and being delivered to the said addressing circuitry (Q9, Q10, Q11, Q12, AL), so as to cause that circuitry to latch a refresh address signal ($Q_n$, $\overline{Q_n}$) supplied thereto;

characterised in that the said clock signal generating circuitry (1, 2A) includes signal modifying means (AND1, L) including loading circuitry (L) operative during the said refresh mode, said loading circuitry reducing the rate of change of an intermediate signal (CAS) derived from the column address strobe signal ($\overline{CAS}$) and employed to determine the timing of the said third clock signal ($\emptyset C$), thereby to cause the time delay between the said first ($\emptyset A$) and third clock signals ($\emptyset C$), during the said refresh mode, to be greater than that between the said first ($\emptyset A$) and second clock signals ($\emptyset B$) during the said read/write mode.

2. A memory as claimed in claim 1, further comprising strobe signal supply means connected to initiate a refresh operation of the memory by delivering the row address strobe signal ($\overline{RAS}$) and the column address strobe signal ($\overline{CAS}$) to the clock signal generating circuitry (1, 2A) substantially simultaneously.

3. A memory as claimed in claim 1 or 2, wherein the said loading circuitry (L) comprises a capacitive load.

4. A memory as claimed in claim 1, 2 or 3, wherein the said clock signal generating circuitry (1, 2A) further comprises a series of inverters (INV1 to INV4) having an input for receiving the said row address strobe signal ($\overline{RAS}$) and having a first output, between two of the inverters (INV2, INV3), at which an inverted row address strobe signal (RAS) is provided, and a second output, at which the said first clock signal ($\emptyset A$) is provided, and wherein the said signal modifying means (AND1, L) thereof further include an AND gate (AND1) connected to receive the said inverted row address strobe signal (RAS) and the said column address strobe signal ($\overline{CAS}$) from which signals the AND gate derives the said intermediate signal (CAS), which signal is delivered to another inverter (INV5) of the clock signal generating circuitry (1, 2A) to obtain an internal clock signal ($\emptyset X$), the modified intermediate signal (CAS) and the said internal clock signal ($\emptyset X$) being supplied respectively to second and third AND gates (AND2, AND3) of the clock signal generating circuitry (1, 2A), each of which second and third AND gates (AND2, AND3) also receives the said first clock signal ($\emptyset A$), the said second clock signal ($\emptyset B$) being provided at an output of the said third AND gate (AND3) and the said third clock signal ($\emptyset C$) being provided at an output of the said second AND gate (AND2).

5. A memory as claimed in claim 4, wherein the said clock signal generating circuitry (1, 2A) further comprises a NOR gate (NOR), connected for receiving the said second and third clock signals ($\emptyset B$, $\emptyset C$), and a further inverter (INV6) having an input connected to the output of the said NOR gate (NOR), a fourth clock signal ($\emptyset L$) being provided at an output of the said further inverter (INV6).

6. A memory as claimed in claim 1, 2 or 3, wherein the said clock signal generating circuitry (1, 2A) further comprises a series of inverters (INV7 to INV10) connected for receiving at an output thereof an additional signal (AE) generated by delaying the row address strobe signal ($\overline{RAS}$) and for providing at an output thereof the said first clock signal ($\emptyset_A$), a NAND gate (NAND1) connected for receiving the said first, second and third clock signals ($\emptyset A$, $\emptyset B$, $\emptyset C$) and producing a control signal (ALE) on the basis of those clock signals, first and second CMOS inverters (Q13, Q14; Q15, Q16), each comprising a P-channel transistor (Q13; Q15) and an N-channel transistor (Q14; Q16) connected together in series, respective sources of the N-channel transistors (Q14; Q16) being connected to receive the said first clock signal ($\emptyset A$), and the said second and third clock signals ($\emptyset B$, $\emptyset C$) being provided at respective outputs of the first and second CMOS inverters, a NOR gate (NOR) having inputs connected to receive the said control signal (ALE) and the modified intermediate signal (CAS) and an output connected to an input of the said first CMOS inverter (Q13; Q15), and a gate transistor (Q17) connected to supply the said modified intermediate signal (CAS) to an input of the said second CMOS inverter (Q14; Q16) in accordance with an inverted version of the control signal (ALE).

7. A memory as claimed in claim 6, wherein the said clock signal generating circuitry (1, 2A) further comprises an additional inverter (INV11) connected to receive and invert the said control signal (ALE) so as to produce a fourth clock signal (ØL).

8. A memory as claimed in any preceding claim, wherein the said addressing circuitry (Q9, Q10, Q11, Q12, AL) comprises address latch means (AL), having respective first and second inputs connected to first and second nodes (N1, N2) of the circuitry, first and second gate transistors (Q9, Q10) connected to deliver an external address signal ($A_n$) and a reference signal ($V_{rf}$) to the said first and second nodes (N1, N2) respectively upon receipt of the said second clock signal (ØB), and third and fourth gate transistors (Q11, Q12) connected to deliver a refresh address signal ($Q_n$) and a complementary refresh address signal ($\overline{Q_n}$) to the said first and second nodes (N1, N2) upon receipt of the said third clock signal (ØC).

9. A memory as claimed in claim 8, when read as appended to claim 6 or 7, wherein the said addressing circuitry further comprises address buffer means (21) including a NAND gate (NAND2) and an inverter (INV13) connected together in series for converting the external address signal ($A_n$) from the TTL level voltage to the MOS level voltage in accordance with the said additional signal (AE).

## Revendications

1. Mémoire dynamique à accès aléatoire comprenant :

une pluralité (11) de cellules mémoire de type dynamique, disposées en rangées et en colonnes, pour stocker des unités respectives de données ;

une circuiterie de commande de rafraîchissement (4, 5) pour provoquer le rafraîchissement des données parmi celles sélectionnées de ces cellules mémoire, quand la mémoire est dans un mode de rafraîchissement, et comprenant une circuiterie d'adresse (5) de rafraîchissement pour générer des signaux d'adresse de rafraîchissement ($Q_n$, $\overline{Q_n}$) indiquant les cellules mémoire à rafraîchir ; et

une circuiterie générant un signal d'horloge (1, 2A) connectée de façon à recevoir des signaux de commande d'adresse de rangée ($\overline{RAS}$) et des signaux de commande d'adresse de colonne ($\overline{CAS}$), et fonctionnant en fonction de ces signaux pour générer un premier signal d'horloge (ØA), quand une durée prédéterminée de temps s'est écoulée après la réception d'un signal de commande d'adresse de rangée ($\overline{RAS}$), et pour générer des second (ØB) et troisième (ØC) signaux d'horloge en réponse au dit premier signal d'horloge (ØA), le dit second signal d'horloge (ØB) étant généré pendant un mode de lecture/ écriture de la mémoire et étant fourni à la circuiterie d'adressage (Q9, Q10, Q11, Q12, AL) de la mémoire de façon à provoquer le maintien par ce circuit d'un signal d'adresse externe ($A_n$) qui lui est fourni, et le dit troisième signal d'horloge (ØC) étant généré pendant le dit mode de rafraîchissement et étant fourni à la dite circuiterie d'adressage (Q9, Q10, Q11, Q12, AL) de façon à provoquer le verrouillage par cette circuiterie d'un signal d'adresse de rafraîchissement ($Q_n$, $\overline{Q_n}$) qui lui est fourni ;

caractérisée en ce que la dite circuiterie générant un signal d'horloge (1, 2A) comporte des moyens de modification du signal (AND1, L) comprenant une circuiterie de chargement (L) active pendant le dit mode de rafraîchissement, la dite circuiterie de chargement étant destinée à réduire le taux de variation d'un signal intermédiaire (CAS) provenant du signal de commande d'adresse de colonne ($\overline{CAS}$) et employé pour déterminer le séquencement du dit troisième signal d'horloge (ØC), de façon à ce qu'un temps de retard, entre les dits premier (ØA) et troisième (ØC) signaux d'horloge, pendant le dit mode de rafraîchissement, devienne plus grand que celui d'entre les dits premier (ØA) et second (ØB) signaux d'horloge pendant le dit mode de lecture/ écriture.

2. Mémoire selon la revendication 1, comprenant de plus des moyens d'alimentation d'un signal de commande connectés pour initier une opération de rafraîchissement de la mémoire en fournissant le signal ($\overline{RAS}$) de commande d'adresse de rangée et le signal ($\overline{CAS}$) de commande d'adresse de colonne à la circuiterie générant le signal d'horloge (1, 2A) pratiquement en même temps.

3. Mémoire selon les revendications 1 ou 2, dans laquelle la circuiterie de charge (L) comporte une charge capacitive.

4. Mémoire selon les revendications 1, 2 ou 3 dans laquelle la dite circuiterie générant un signal d'horloge (1,2A) comporte de plus une série d'inverseurs (INV1 à INV4) présentant une entrée pour recevoir le dit signal (RAS) de commande d'adresse de rangée et présentant une première sortie entre deux des inverseurs (INV2, INV3), sur laquelle un signal (RAS) inversé de commande d'adresse de rangée est fourni, et une seconde sortie, sur laquelle le dit premier signal d'horloge (ØA) est produit et, mémoire dans laquelle les dits moyens de modification de signal (AND1, L) y comportent de plus une porte ET (AND1) connectée de façon à recevoir le dit signal de commande d'adresse de rangée inversée (RAS) et le dit signal de commande d'adresse de colonne (CAS) à l'aide desquels signaux la porte ET élabore le dit signal intermédiaire (CAS), lequel signal est fourni à un autre inverseur (INV5) de la circuiterie générant le signal d'horloge (1,2A) pour obtenir un signal d'horloge interne (ØX), le signal intermédiaire modifié (CAS) et le dit signal d'horloge interne (ØX) étant fourni respectivement aux seconde et troisième portes ET (AND2, AND3) de la circuiterie générant le signal d'horloge (1, 2A) chacune desquelles seconde et troisième portes ET (AND2, AND3) reçoit aussi le dit premier signal d'horloge (ØA) le dit second signal d'horloge (ØB) étant fourni à une sortie de la dite troisième porte ET (AND3) et le dit troisième signal d'horloge (ØC) étant fourni à une sortie de la dite seconde porte ET (AND2).

5. Mémoire selon la revendication 1, dans laquelle la dite circuiterie générant un signal d'horloge (1,2A) comporte de plus une porte NON OU (NOR) connectée de façon à recevoir les dits second et troisième signaux d'horloge (ØB et ØC), et un inverseur supplémentaire (INV6) ayant une entrée connectée à la sortie de la dite porte NON OU (NOR), un quatrième signal d'horloge (ØL) étant fourni à une sortie du dit inverseur supplémentaire (INV6).

6. Mémoire selon les revendications 1, 2 ou 3, dans laquelle la dite circuiterie générant un signal d'horloge (1, 2A) comporte de plus une série d'inverseurs (INV7 à INV10) connectés de façon à recevoir sur une sortie un signal additionnel (AE) généré en retardant le signal de commande d'adresse de rangée (RAS) et pour fournir à une sortie le dit premier signal d'horloge (ØA), une perte NON ET (NAND1) connectée de façon à recevoir les dits premier, second et troisième signaux d'horloge (ØA, ØB et ØC) et produisant un signal de commande (ALE) sur la base de ces signaux d'horloge, des premier et second inverseurs CMOS (Q13, Q14 ; Q15, Q16), chacun comprenant un transistor à canal P (Q13 ; Q15) et un transistor à canal N (Q14 ; Q16) connectés ensemble en série, les sources respectives des transistors à canal N (Q14, Q16) étant connectées de façon à recevoir le dit premier signal d'horloge (ØA), et les dits second et troisième signaux d'horloge (ØB et ØC) étant fournis aux sorties respectives des premier et second inverseurs CMOS, une porte NON OU (NOR) ayant des entrées connectées de façon à recevoir le dit signal de commande (ALE) et le signal intermédiaire modifié (CAS) et une sortie connectée à une entrée du dit premier inverseur CMOS (Q13 ; Q15), et un transistor d'attaque (Q17) connecté pour fournir le dit signal intermédiaire modifié (CAS) à une entrée du dit second inverseur CMOS (Q14 ; Q16) selon une version inversée du signal de commande (ALE).

7. Mémoire selon la revendication 6, dans laquelle la dite circuiterie générant un signal d'horloge (1, 2A) comporte de plus un inverseur additionnel (INV11) connecté de façon à recevoir et inverser le dit signal de commande (ALE) de façon à produire un quatrième signal d'horloge (ØL).

8. Mémoire selon l'une quelconque des revendications précédentes, dans laquelle la dite circuiterie d'adressage (Q9, Q10, Q11, Q12, AL) comporte des moyens de maintien d'adresse (AL) ayant des première et seconde entrées respectives connectées aux premier et second noeuds (N1, N2) de la circuiterie, des premier et second transistors d'attaque (Q9 et Q10) connectés pour fournir un signal d'adresse externe (A_n) et un signal de référence (V_rf) aux dits premier et second noeuds (N1 et N2) respectivement à la réception du dit second signal d'horloge (ØB) et des troisième et quatrième transistors d'attaque (Q11, Q12) connectés pour fournir un signal d'adresse de rafraîchissement (Q_n) et un signal d'adresse de rafraîchissement complémentaire (Q̄_n) aux dits premier et second noeuds (N1, N2) à la réception du dit troisième signal d'horloge (ØC).

9. Mémoire selon la revendication 8, pour ce qu'elle est annexée aux revendications 6 ou 7, dans laquelle la dite circuiterie d'adressage comporte de plus des moyens tampon d'adresse (21) comprenant une porte NON ET (NAND) et un inverseur (INV13) connectés ensemble en série pour convertir le signal d'adresse externe (An) du niveau de tension TTL au niveau de tension MOS selon le dit signal additionnel (AE).

## Ansprüche

1. Dynamischer Speicher mit wahlfreiem Zugriff mit:

     einer Vielzahl (11) von Speicherzellen vom dynamischen Typ, die in Reihen und Spalten angeordnet sind, um entsprechende Größen von Daten zu speichern;

     Auffrischsteuerschaltungen (4, 5), um zu verursachen, daß Daten in ausgewählten jener Speicherzellen aufgefrischt werden, wenn der Speicher sich im Auffrischmodus befindet, und mit Auffrischadreßschaltungen (5) zum Generieren von Auffrischadreßsignalen ($Q_n$, $\overline{Q}_n$), welche aufzufrischende Speicherzellen bezeichnen; und

     Taktsignalgeneratorschaltungen (1, 2A), die verbunden sind, um Reihenadreßimpulssignale ($\overline{RAS}$) und Spaltenadreßimpulssignale ($\overline{CAS}$) zu empfangen und abhängig davon tätig werden, um ein erstes Taktsignal ($\Phi$A) zu erzeugen, wenn eine vorbestimmte Zeitlänge nach Empfang eines Reihenadreßimpulssignals ($\overline{RAS}$) verstrichen ist, und um zweite ($\Phi$B) und dritte ($\Phi$C) Taktsignale in Abhängigkeit von dem genannten ersten Taktsignal ($\Phi$A) zu erzeugen, wobei das genannte zweite Taktsignal ($\Phi$B) während eines Lese/Schreibmodus des Speichers erzeugt wird, und an eine Adressierschaltung (Q9, Q10, Q11, Q12, AL) des Speichers geliefert wird, um so zu verursachen, daß die Schaltung ein externes Adreßsignal ($A_n$), das ihm zugeführt wird, verriegelt, und das genannte dritte Taktsignal ($\Phi$C) während des genannten Auffrischmodus erzeugt wird und an die genannte Adressierschaltung (Q9, Q10, Q11, Q12, AL) geliefert wird, um so zu verursachen, daß die Schaltung ein ihr zugeführtes Auffrischadreßsignal ($Q_n$, $\overline{Q}_n$) verriegelt;

     dadurch gekennzeichnet, daß die genannten Taktsignalgeneratorschaltungen (1, 2A) eine Signalmodifizierungseinrichtung (AND1, L) enthalten, die eine Lastschaltung (L) enhält, die während des genannten Auffrischmodus tätig ist, welche Lastschaltung die Geschwindigkeit einer Änderung eines Zwischensignals (CAS) reduziert, das von dem Spaltenadreßimpulssignal ($\overline{CAS}$) abgeleitet und verwendet wird, um die Zeitlage des genannten dritten Taktsignals ($\Phi$C) zu bestimmen, um dadurch zu verursachen, daß die Zeitverzögerung zwischen den genannten ersten ($\Phi$A) und dritten Taktsignalen ($\Phi$C) während des genannten Auffrischmodus größer als jene zwischen den genannten ersten ($\Phi$A) und zweiten Taktsignalen ($\Phi$B) während des genannten Lese/Schreibmodus ist.

2. Speicher nach Anspruch 1, ferner mit einer Impulssignalversorgungseinrichtung, die angeschlossen ist, um einen Auffrischbetrieb des Speichers zu initiieren, durch im wesentlichen gleichzeitige Lieferung des Reihenadreßimpulssignals ($\overline{RAS}$) und des Spaltenadreßimpulssignals ($\overline{CAS}$) an die Taktsignalgeneratorschaltungen (1, 2A).

3. Speicher nach Anspruch 1 oder 2, bei dem die genannte Lastschaltung (L) eine kapazitive Last umfaßt.

4. Speicher nach Anspruch 1, 2 oder 3, bei dem die genannten Taktsignalgeneratorschaltungen (1, 2A) ferner eine Reihe von Invertern (INV1 bis INV4) umfassen, die einen Eingang zum Empfang des genannten Reihenadreßimpulssignals ($\overline{RAS}$) haben und einen ersten Ausgang haben, zwischen zwei der Inverter (INV2, INV3), bei dem ein invertiertes Reihenadreßimpulssignal (RAS) vorgesehen wird, und einen zweiten Ausgang, bei dem das genannte erste Taktsignal ($\Phi$A) vorgesehen ist, und bei dem die genannte Signalmodifizierungseinrichtung (AND1, L) davon ferner ein UND-Gatter (AND1) umfaßt, das verbunden ist, um das genannte Reihenadreßimpulssignal (RAS) und das genannte Spaltenadreßimpulssignal ($\overline{CAS}$) zu empfangen, von welchen Signalen das UND-Gatter das genannte Zwischensignal ($\overline{CAS}$) ableitet, welches Signal an einen anderen Inverter (INV5) der Taktsignalgeneratorschaltungen (1, 2A) geliefert wird, um ein internes Taktsignal ($\Phi$X) zu erhalten, wobei das modifizierte Zwischensignal (CAS) und das genannte interne Taktsignal ($\Phi$X) jeweils den zweiten und dritten UND-Gattern (AND2, AND3) der Taktsignalgeneratorschaltungen (1, 2A) geliefert wird, von denen jedes zweite und dritte UND-Gatter (AND2, AND3) auch das erste Taktsignal ($\Phi$A) empfängt, und das genannte zweite Taktsignal ($\Phi$B) an einem Ausgang des genannten dritten UND-Gatters (AND3) vorgesehen ist, und das genannte dritte Taktsignal ($\Phi$C) an einem Ausgang des genannten zweiten UND-Gatters (AND2) vorgesehen ist.

5. Speicher nach Anspruch 4, bei dem die genannten Taktsignalgeneratorschaltungen (1, 2A) ferner ein NOR-Gatter (NOR) umfassen, das verbunden ist, um die genannten zweiten und dritten Signale ($\Phi$B, $\Phi$C) zu empfangen,

und ein weiterer Inverter (INV6) einen Eingang hat, der mit dem Ausgang des genannten NOR-Gatters (NOR) verbunden ist, und ein viertes Taktsignal ($\Phi$L) an einem Ausgang des genannten weiteren Inverters (INV6) vorgesehen ist.

6. Speicher nach Anspruch 1, 2 oder 3, bei dem die genannten Taktsignalgeneratorschaltungen (1, 2A) ferner eine Reihe von Invertern (INV7 bis INV10) umfassen, die verbunden sind, um an einem Ausgang davon ein zusätzliches Signal (AE) zu empfangen, welches durch Verzögern des Reihenadreßimpulssignals ($\overline{RAS}$) erzeugt wurde, und um an einem Ausgang davon das genannte erste Taktsignal ($\Phi_A$) vorzusehen, ein NAND-Gatter (NAND1), das verbunden ist, um die genannten ersten, zweiten und dritten Taktsignale ($\Phi$A, $\Phi$B, $\Phi$C) zu empfangen und ein Steuersignal (ALE) auf der Basis jener Taktsignale zu erzeugen, erste und zweite CMOS-Inverter (Q13, Q14; Q15, Q16), die jeweils einen P-Kanal-Transistor (Q13; Q15) und einen N-Kanal-Transistor (Q14; Q16) umfassen, die miteinander in Reihe verbunden sind, wobei jeweilige Sourcen der N-Kanal-Transistoren (Q14; Q16) verbunden sind, um das genannte erste Taktsignal ($\Phi$A) zu empfangen und die zweiten und dritten Taktsignale ($\Phi$B, $\Phi$C) an jeweiligen Ausgängen der ersten und zweiten CMOS-Inverter vorgesehen sind, ein NOR-Gatter (NOR), das Eingänge hat, die verbunden sind, um das genannte Steuersignal (ALE) und das modifizierte Zwischensignal (CAS) zu empfangen, und einen Ausgang, der mit einem Eingang des genannten ersten CMOS-Inverters (Q13; Q15) verbunden ist, und einen Gatetransistor (Q17), der verbunden ist, um das genannte modifizierte Zwischensignal (CAS) an einen Eingang des genannten zweiten CMOS-Inverters (Q14; Q16) zu liefern, in Übereinstimmung mit einer invertierten Version des Steuersignals (ALE).

7. Speicher nach Anspruch 6, bei dem die genannten Taktsignalgeneratorschaltungen (1, 2A) ferner einen zusätzlichen Inverter (INV11) umfassen, der verbunden ist, um das genannte Steuersignal (ALE) zu empfangen und zu invertieren, um so ein viertes Taktsignal ($\Phi$L) zu erzeugen.

8. Speicher nach einem der vorhergehenden Ansprüche, bei dem die genannte Adressierschaltung (Q9, Q10, Q11, Q12, AL) eine Adreßverriegelungseinrichtung (AL) umfaßt, die jeweils erste und zweite Eingänge haben, die mit ersten und zweiten Knoten (N1, N2) der Schaltung verbunden sind, erste und zweite Gatetransistoren (Q9, Q10), die verbunden sind, um ein externes Adreßsignal ($A_n$) und ein Referenzsignal ($V_{rf}$) an die genannten ersten bzw. zweiten Knoten (N1, N2) bei Empfang des genannten zweiten Taktsignals ($\Phi$B) zu liefern, und dritte und vierte Gatetransistoren (Q11, Q12), die verbunden sind, um ein Auffrischadreßsignal ($Q_n$) und ein komplementäres Auffrischadreßsignal ($\overline{Q}_n$) bei Empfang des genannten dritten Taktsignals ($\Phi$C) an die genannten ersten und zweiten Knoten (N1, N2) zu liefern.

9. Speicher nach Anspruch 8, in Verbindung mit Anspruch 6 oder 7, bei dem die genannten Adressierschaltungen ferner Adreßpuffereinrichtungen (21) umfassen, die ein NAND-Gatter (NAND2) und einen Inverter (INV13) umfassen, die miteinander in Reihe verbunden sind, um das externe Adreßsignal ($A_n$) von der TTL-Pegelspannung zu der MOS-Pegelspannung zu konvertieren, in Übereinstimmung mit dem zusätzlichen Signal (AE).

Fig. I

RAS 15

CAS 16

RAS BUFFER 17

φL

φA

18

TG1 Vcc

TR1

φC

TR3

φB

TR4

GND

TR2 Vcc

TG2

19

# Fig. 2

*Fig. 3*

*Fig. 4*

EP 0 260 039 B1

Fig. 5

Fig. 6

Fig. 7

# Fig. 8

EP 0 260 039 B1

# Fig. 9

# Fig. 10

# Fig. 11

# Fig. 12

## Fig. 13

## Fig. 14

# Fig. 15

EP 0 260 039 B1